# FASCICULE DE BREVET EUROPEEN

(11) **EP 3 164 881 B1**
(45) Date de publication et mention de la délivrance du brevet: **18.05.2022**
(21) Numéro de dépôt: 15732197.7
(22) Date de dépôt: 22.06.2015
(51) Int. Cl.: H01L 21/02, H01L 33/20, H01L 33/08, H01L 31/0352, H01L 31/0304, H01L 33/18, H01L 33/32

(54) **DISPOSITIF OPTOELECTRONIQUE A ELEMENTS SEMICONDUCTEURS ET SON PROCEDE DE FABRICATION**
OPTOELEKTRONISCHE VORRICHTUNG MIT HALBLEITERBAUELEMENTEN UND VERFAHREN ZUR HERSTELLUNG DAVON
OPTOELECTRONIC DEVICE HAVING SEMICONDUCTOR ELEMENTS AND METHOD FOR MANUFACTURING SAME

(30) Priorité: 02.07.2014 FR 1456317
(43) Date de publication de la demande: 10.05.2017
(73) Titulaire: Aledia, 38130 Echirolles (FR)
(72) Inventeur: DECHOUX, Nathalie, 38430 Moirans (FR); LACAVE, Thomas, 38000 Grenoble (FR); AMSTATT, Benoît, 38000 Grenoble (FR); GIBERT, Philippe, 38960 St Etienne de Crossey (FR)
(74) Mandataire: Cabinet Beaumont
(86) Numéro de dépôt international: PCT/EP2015/063895
(87) Numéro de publication internationale: WO 2016/000990

(56) Documents cités:
- EP-A1- 2 254 164
- EP-A1- 2 333 847
- WO-A1-2011/117056
- JP-A- 2006 339 534
- US-A1- 2002 117 104
- LI SHUNFENG ET AL: "GaN based nanorods for solid state lighting", JOURNAL OF APPLIED PHYSICS, AMERICAN INSTITUTE OF PHYSICS, US, vol. 111, no. 7, avril 2012 (2012-04), pages 71101-71101, XP012158656, ISSN: 0021-8979, DOI: 10.1063/1.3694674 [extrait le 2012-04-02]
- None

## Description

La présente demande de brevet revendique la priorité de la demande de brevet français FR14/56317.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des éléments semiconducteurs de taille micrométrique ou nanométrique, notamment des microfils, des nanofils semiconducteurs ou des structures de forme pyramidale.

### Exposé de l'art antérieur

Les éléments semiconducteurs de taille micrométrique ou nanométrique, notamment les microfils, les nanofils ou les structures de forme pyramidale comprenant un matériau semiconducteur comportant notamment majoritairement un élément du groupe III et un élément du groupe V (par exemple du nitrure de gallium GaN), appelés par la suite composé III-V, permettent la fabrication de dispositifs semiconducteurs tels que des dispositifs optoélectroniques. Par dispositifs optoélectroniques, on entend des dispositifs adaptés pour effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés aux applications photovoltaïques.

Les procédés de fabrication d'éléments semiconducteurs de taille micrométrique ou nanométrique comprenant un composé III-V doivent permettre la fabrication de ces éléments semiconducteurs avec un contrôle précis et uniforme de la géométrie, de la position et des propriétés cristallographiques de chaque élément semiconducteur.

La fabrication d'un dispositif optoélectronique comprenant des éléments semiconducteurs de taille nanométrique ou micrométrique comprend généralement la formation de germes sur une couche en un matériau favorisant la formation de germes du composé III-V, appelée couche de nucléation, la croissance des éléments semiconducteurs à partir des germes et la formation d'une couche active sur chaque élément semiconducteur. Pour contrôler les emplacements de croissance des éléments semiconducteurs, la couche de nucléation est, par exemple, recouverte d'une couche isolante dans laquelle sont réalisées des ouvertures exposant des portions de la couche de nucléation.

Il est souhaitable qu'un seul germe se forme sur la couche de nucléation dans chaque ouverture. Toutefois, plusieurs germes peuvent se former dans une même ouverture. Ceci peut entraîner la croissance de plusieurs éléments semiconducteurs depuis une même ouverture. Un mauvais contrôle de la croissance de ces éléments semiconducteurs est alors obtenu, notamment en ce qui concerne la hauteur et l'orientation de chaque élément semiconducteur. Ceci peut mener à une dégradation du fonctionnement du dispositif optoélectronique.

En outre, des contraintes mécaniques peuvent apparaître dans le dispositif optoélectronique au cours de la croissance des éléments semiconducteurs en raison des différences de dilatation entre la couche isolante et le substrat. Ces contraintes peuvent perturber le bon fonctionnement du dispositif optoélectronique.

Les documents US2002/0117104, JP2006339534, EP2254164, EP2333847 et WO2011/117056 décrivent des dispositifs optoélectroniques à diodes électroluminescentes.

### Résumé

Un mode de réalisation vise à pallier tout ou partie des inconvénients des dispositifs optoélectroniques et de leurs procédés de fabrication décrits précédemment.

Un mode de réalisation permet d'obtenir la hauteur et l'orientation souhaitées pour chaque élément semiconducteur du dispositif optoélectronique.

Un mode de réalisation permet de réduire, voire de supprimer, l'apparition de contraintes mécaniques dans le substrat au cours de la croissance des éléments semiconducteurs.

La présente invention est exposée dans le jeu de revendications joint.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un dispositif optoélectronique à microfils ou nanofils, non compris dans l'invention revendiquée ;
les figures 2A à 2C sont des coupes, partielles et schématiques, de structures obtenues à des étapes successives d'un procédé de fabrication du dispositif optoélectronique représenté en figure 1 ;
la figure 3 est une vue en coupe, partielle et schématique, d'un mode de réalisation d'un dispositif optoélectronique à microfils ou nanofils ;
les figures 4 et 5 sont des vues en coupe, partielles et schématiques, de modes de réalisation de dispositifs optoélectroniques respectivement à pyramides et pyramides tronquées ;
les figures 6A à 6H, 7A et 7B, 8A à 8H et 9A à 9C sont des coupes, partielles et schématiques, de structures obtenues à des étapes initiales successives de modes de réalisation d'un procédé de fabrication du dispositif optoélectronique représenté en figure 3 ;
les figures 10A à 10C sont des coupes, partielles et schématiques, de structures obtenues à des étapes ultérieures successives d'un mode de réalisation d'un procédé de fabrication du dispositif optoélectronique représenté en figure 3 ;
la figure 11 est une coupe, partielle et schématique, de la structure obtenue à une étape d'un mode de réalisation d'un procédé de fabrication du dispositif optoélectronique représenté en figure 5 ; et
la figure 12 est une vue en coupe, partielle et schématique, d'un mode de réalisation d'un dispositif optoélectronique à microfils ou nanofils.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de polarisation du dispositif optoélectronique sont bien connus et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

Dans la suite de la description, on appelle procédé de dépôt conforme un procédé dans lequel une épaisseur sensiblement constante de matériau est déposée sur toutes les faces exposées d'un substrat. En outre, on appelle procédé de dépôt directif un procédé dans lequel un matériau est déposé sur les faces exposées du substrat qui sont perpendiculaires à une direction donnée mais n'est pas déposé sur les faces exposées du substrat qui sont parallèles à la direction donnée. De plus, on appelle dépôt partiellement conforme un procédé de dépôt intermédiaire entre un procédé de dépôt conforme et un procédé de dépôt directif dans lequel du matériau est déposé sur toutes les faces exposées du substrat, l'épaisseur déposée n'étant toutefois pas constante et dépendant notamment de l'orientation des faces exposées du substrat par rapport à une direction donnée.

La présente description concerne des dispositifs optoélectroniques comprenant des éléments semiconducteurs ayant la forme de microfils, de nanofils ou de pyramides.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Dans la suite de la description, le terme pyramide ou pyramide tronquée désigne une structure tridimensionnelle de forme pyramidale ou conique allongée. Cette structure pyramidale peut être tronquée, c'est-à-dire que le haut du cône est absent, laissant place à un plateau. La base de la pyramide est inscrite dans un polygone dont la dimension des côtés est de 100 nm à 10 µm, préférentiellement entre 1 et 3 µm. Le polygone formant la base de la pyramide peut être un hexagone. La hauteur de la pyramide entre la base de la pyramide et le sommet ou le plateau sommital varie de 100 nm à 20 µm, préférentiellement entre 1 µm et 10 µm.

Dans la suite de la description, des modes de réalisation vont être décrits dans le cas d'un dispositif optoélectronique à diodes électroluminescentes. Toutefois, il est clair que ces modes de réalisation peuvent concerner d'autres applications, notamment des dispositifs dédiés à la détection ou la mesure d'un rayonnement électromagnétique ou des dispositifs dédiés aux applications photovoltaïques.

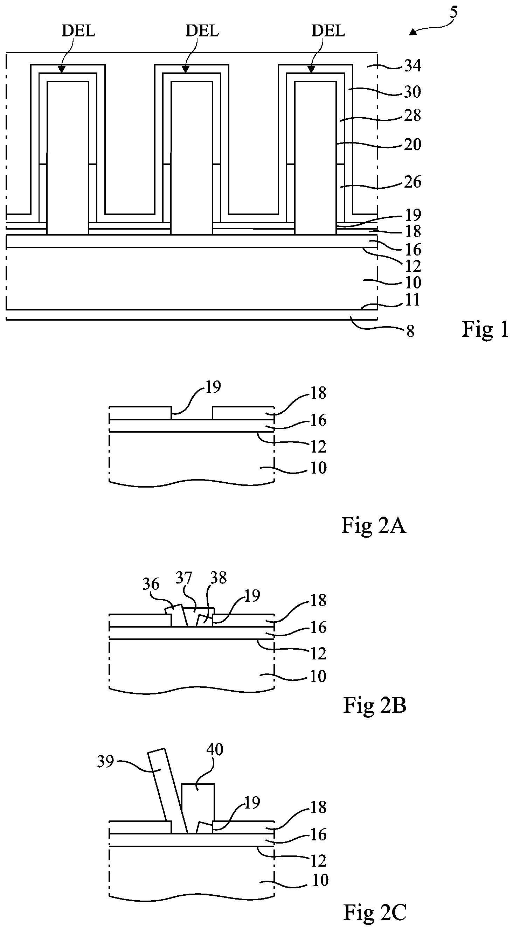

Dans un exemple non compris dans l'invention revendiquée, la figure 1 est une vue en coupe, partielle et schématique, d'un exemple d'un dispositif optoélectronique 5 à diodes électroluminescentes. En figure 1, on a représenté une structure comprenant, du bas vers le haut :
une première électrode 8 ;
un substrat semiconducteur 10 comprenant une face inférieure 11 et une face supérieure 12, la face inférieure 11 étant recouverte de la première électrode 8 et la face supérieure 12 étant de préférence plane au moins au niveau des diodes électroluminescentes ;
une couche de germination 16 en un matériau conducteur favorisant la croissance de fils et disposée sur la face 12 ;
une couche isolante 18 recouvrant la couche de germination 12 et comprenant des ouvertures 19 exposant des portions de la couche de germination 16 ;
des éléments semiconducteurs 20 qui, dans le présent mode de réalisation, ont la forme de fils (trois fils étant représentés), chaque fil 20 étant en contact avec la couche de germination 16 au travers de l'une des ouvertures 19 ;
une couche isolante 26 s'étendant sur la couche isolante 18 et sur les flancs latéraux d'une portion inférieure de chaque fil 20 ;
une coque 28 comprenant un empilement de couches semiconductrices recouvrant une portion supérieure de chaque fil 20 ;
une couche 30 formant une deuxième électrode recouvrant chaque coque 28 et s'étendant, en outre, sur la couche isolante 26 ; et
une couche d'encapsulation 34 recouvrant l'ensemble de la structure et notamment l'électrode 30.

L'ensemble formé par chaque fil 20 et la coque 28 associée constitue une diode électroluminescente DEL. La coque 28 comprend notamment une couche active qui est la couche depuis laquelle est émise la majorité du rayonnement électromagnétique fourni par la diode électroluminescente DEL. Les diodes électroluminescentes DEL peuvent être connectées en parallèle et former un ensemble de diodes électroluminescentes. L'ensemble peut comprendre de quelques diodes électroluminescentes DEL à un millier de diodes électroluminescentes.

Dans un exemple non compris dans l'invention revendiquée, les figures 2A à 2C illustrent les étapes initiales d'un exemple de procédé de fabrication du dispositif optoélectronique 5 représenté en figure 1.

La figure 2A représente la structure obtenue après les étapes suivantes :
formation sur la face 12 du substrat 10 de la couche de germination 16, par exemple par épitaxie ;
formation de la couche isolante 18 sur la couche de germination 16 ;
formation des ouvertures 19 dans la couche isolante 18, une seule ouverture 19 étant représentée sur les figures 2A à 2C.

La couche isolante 18 peut être en un matériau diélectrique, par exemple en oxyde de silicium (SiO₂). A titre d'exemple, l'épaisseur de la couche isolante 18 est comprise entre 5 nm et 2 µm, par exemple égale à environ 30 nm. La section de chaque ouverture 19 correspond sensiblement à la section souhaitée du fil 20. De préférence, le diamètre du fil 20 est compris entre 100 nm et 1 µm, de préférence entre 300 nm et 800 nm.

La figure 2B représente la structure obtenue après la croissance de germes dans les ouvertures 19, par exemple par dépôt chimique en phase vapeur organométallique (MOCVD, acronyme anglais pour Metal-Organic Chemical Vapor Déposition). Les inventeurs ont mis en évidence que plusieurs germes peuvent se former dans une même ouverture 19, trois germes 36, 37, 38 étant représentés à titre d'exemple en figure 2B.

La figure 2C représente la structure obtenue après la croissance de fils. Comme cela apparaît sur cette figure, lorsque plusieurs germes 36, 37, 38 sont initialement présents dans une même ouverture 19, plusieurs fils 39, 40 peuvent croître depuis cette ouverture 19 avec des axes de croissance différents.

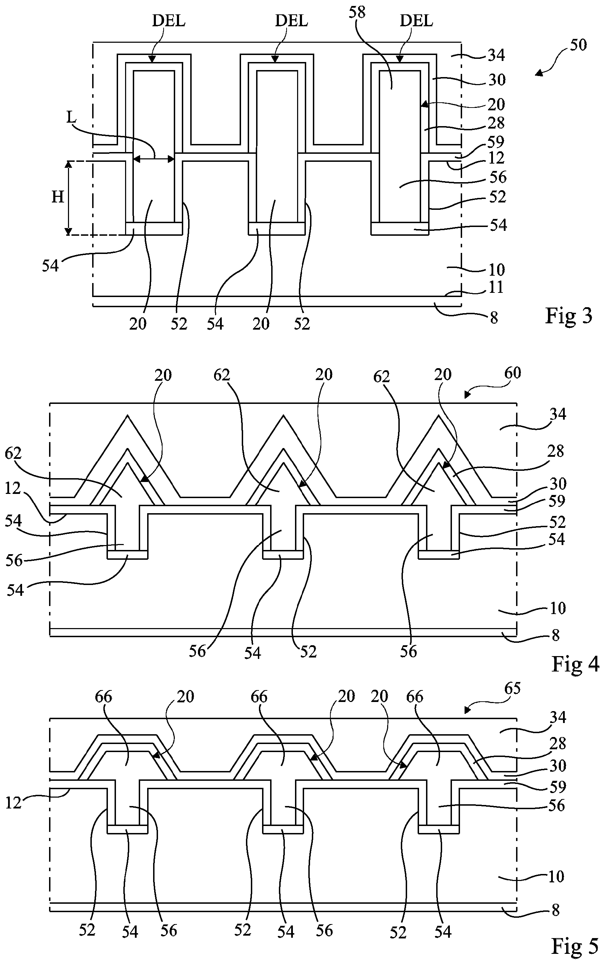

La figure 3 est une vue en coupe, partielle et schématique, d'un mode de réalisation d'un dispositif optoélectronique 50 à diodes électroluminescentes dont les éléments semiconducteurs correspondent à des nanofils ou microfils.

Le dispositif optoélectronique 50 comprend les mêmes éléments que le dispositif optoélectronique 5 représenté en figure 1 à la différence qu'il comprend des ouvertures 52 formées dans le substrat 10 dans chacune desquelles croît l'un des fils 20. Les ouvertures 52 sont non traversantes. En outre, la couche 18 n'est pas présente. De plus, la couche de nucléation 16 est remplacée par des plots ou îlots de nucléation 54, du même matériau que la couche de nucléation 16, les plots de nucléation 54 étant situés au fond des ouvertures 52. Chaque fil 20 repose sur l'un des plots de nucléation 54. Dans la suite de la description, on appelle sommet de l'ouverture 52 l'extrémité de l'ouverture 52 la plus éloignée du plot de nucléation 54 et base de l'ouverture 52 l'extrémité de l'ouverture 52 sur laquelle repose le plot de nucléation 54. Chaque fil 20 comprend une portion inférieure 56 dans l'ouverture 52 et une portion supérieure 58 en forme de fil à l'extérieur de l'ouverture 52. Le dispositif optoélectronique 50 comprend, en outre, une couche isolante 59 qui s'étend sur la face 12 du substrat 10 et sur les parois latérales, à l'exception du fond, de chaque ouverture 52.

La figure 4 est une vue en coupe, partielle et schématique, d'un autre mode de réalisation d'un dispositif optoélectronique 60 à diodes électroluminescentes. Le dispositif optoélectronique 60 comprend les mêmes éléments que le dispositif optoélectronique 50 représenté en figure 3 à la différence que la portion supérieure 58 en forme de fil est remplacée par une portion pyramidale 62 en dehors de l'ouverture 52. La base de la pyramide 62 peut reposer sur le substrat 10 et est plus large que l'ouverture 52 sous-jacente.

La figure 5 est une vue en coupe, partielle et schématique, d'un autre mode de réalisation d'un dispositif optoélectronique 65 à diodes électroluminescentes. Le dispositif optoélectronique 65 comprend les mêmes éléments que le dispositif optoélectronique 60 représenté en figure 4 à la différence que chaque pyramide 62 est remplacée par une pyramide tronquée 66. Dans la suite de la description, sauf indication contraire, le terme pyramide désigne indifféremment une pyramide complète 62 telle que représentée en figure 4 ou une pyramide tronquée 66 telle que représentée en figure 5.

Dans le cas des éléments semiconducteurs 20 en forme de fils, le diamètre du fil est sensiblement le même que le diamètre de l'ouverture 52 correspondant. Dans le cas des pyramides 62, 66, on note un élargissement de la structure semiconductrice dès la sortie de l'ouverture 52.

La section droite des ouvertures 52 peut avoir différentes formes, telles que, par exemple, une forme ovale, circulaire ou polygonale, notamment triangulaire, rectangulaire, carrée ou hexagonale. Lorsque l'on mentionne ici le "diamètre" dans une section droite d'une ouverture ou d'un fil, il s'agit d'une grandeur associée à la surface de la structure visée dans cette section droite, correspondant au diamètre du disque ayant la même surface que la section droite de l'ouverture ou du fil. Ce même principe de diamètre équivalent est appliqué aux structures pyramidales notamment pour la base de la pyramide.

On appelle H la hauteur de l'ouverture 52, et L le diamètre de l'ouverture 52. Selon un mode de réalisation, le diamètre L de l'ouverture 52 est sensiblement constant sur toute la hauteur H. A titre d'exemple, la hauteur H de chaque ouverture 52 est comprise entre 25 nm et 5 µm, de préférence entre 200 nm et 2000 nm, encore plus préférentiellement entre 300 nm et 1000 nm. A titre d'exemple, le diamètre L de chaque ouverture 52 est compris entre 10 nm et 2 µm, de préférence entre 100 nm et 600 nm. Le rapport F entre la hauteur H et le diamètre L est compris entre 0,5 et 15, de préférence entre 1 et 10.

Les inventeurs ont mis en évidence que lorsque les ouvertures 52 avaient les dimensions H, L et F indiquées précédemment, il était observé la croissance d'un seul fil 20 par ouverture 52.

Le substrat 10 correspond à une structure monobloc . Le substrat 10 est un substrat en silicium, en germanium, en carbure de silicium, en un composé III-V, tel que du GaN ou du GaAs, ou un substrat en ZnO. De préférence, le substrat 10 est un substrat de silicium monocristallin. De préférence, il s'agit d'un substrat semiconducteur compatible avec les procédés de fabrication mis en oeuvre en microélectronique.

Le substrat 10 peut être fortement dopé, faiblement dopé ou non dopé. Dans le cas où le substrat est fortement dopé, le substrat semiconducteur 10 peut être dopé de façon à baisser la résistivité électrique jusqu'à une résistivité proche de celle des métaux, de préférence inférieure à quelques mohm.cm. Le substrat 10 est, par exemple, un substrat fortement dopé avec une concentration de dopants comprise entre 5*10¹⁶ atomes/cm³ et 2^{*}10²⁰ atomes/cm³. Dans le cas où le substrat est faiblement dopé, par exemple avec une concentration de dopants inférieure ou égale à 5*10¹⁶ atomes/cm3, de préférence sensiblement éqale à 10¹⁵ atomes/cm3, une région dopée du premier type de conductivité ou d'un deuxième type de conductivité, opposé au premier type, plus fortement dopée que le substrat peut être prévue qui s'étend dans le substrat 10 depuis la face 12. Dans le cas d'un substrat 10 de silicium, des exemples de dopants de type P sont le bore (B) ou l'indium (In) et des exemples de dopants de type N sont le phosphore (P), l'arsenic (As), ou l'antimoine (Sb). La face 12 du substrat 10 de silicium peut être une face (100).

Les plots de germination 54 sont en un matériau favorisant la croissance des éléments semiconducteurs 20. Les plots de germination 54 sont en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. Les plots de germination 54 peuvent être dopés du même type de conductivité que le substrat 10. Les plots de germination 54 ont, par exemple, une épaisseur comprise entre 1 et 100 nanomètres, de préférence comprise entre 10 et 30 nanomètres.

La couche isolante 59 est en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant. A titre d'exemple, l'épaisseur de la couche isolante 59 est comprise entre 5 nm et 100 nm, par exemple égale à environ 30 nm. La couche isolante 59 peut avoir une structure monocouche ou correspondre à un empilement de deux couches ou de plus de deux couches.

Les éléments semiconducteurs 20 sont, au moins en partie, formés à partir d'au moins un matériau semiconducteur. Le matériau semiconducteur est un composé III-V, un composé II-VI ou une combinaison d'au moins deux de ces composés.

Les éléments semiconducteurs 20 sont, au moins en partie, formés à partir de matériaux semiconducteurs comportant majoritairement un composé III-V, par exemple un composé III-N. Des exemples d'éléments du groupe III comprennent le gallium (Ga) , l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les éléments semiconducteurs 20 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te) . Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les éléments semiconducteurs 20 peuvent comprendre un dopant, notamment dans la portion inférieure 56. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg) , un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

Lorsque les éléments semiconducteurs 20 correspondent à des fils, la hauteur de la portion supérieure 58, en dehors de l'ouverture 52, peut être comprise entre 250 nm et 50 µm. Chaque fil 20 peut avoir une structure semiconductrice allongée selon un axe sensiblement perpendiculaire à la face 12. Chaque fil 20 peut avoir une forme générale cylindrique, notamment à base circulaire ou hexagonale. Les axes de deux fils 20 adjacents peuvent être distants de 0,5 µm à 10 µm et de préférence de 1,5 µm à 5 µm. A titre d'exemple, les fils 20 peuvent être régulièrement répartis, notamment selon un réseau hexagonal.

La hauteur de chaque pyramide 62, 66 peut être comprise entre 100 nm et 25 µm. Chaque pyramide peut avoir une structure semiconductrice allongée selon un axe sensiblement perpendiculaire à la face 12. La base de chaque pyramide 62, 66 peut avoir une forme générale de type ovale, circulaire ou polygonale, notamment triangulaire, rectangulaire, carrée ou hexagonale. Les centres de deux pyramides adjacentes peuvent être distants de 0,25 µm à 10 µm et de préférence de 1,5 µm à 5 µm. A titre d'exemple, les pyramides peuvent être régulièrement réparties, notamment selon un réseau hexagonal.

La coque 28 peut comprendre un empilement de plusieurs couches comprenant notamment :
- une couche active recouvrant la portion supérieure 58 ou la pyramide 62, 66 associée ;
- une couche intermédiaire de type de conductivité opposé à la portion inférieure 56 et recouvrant la couche active ; et
- une couche de liaison recouvrant la couche intermédiaire et recouverte par l'électrode 30.

La couche active est la couche depuis laquelle est émise la majorité du rayonnement fourni par la diode électroluminescente DEL. Selon un exemple, la couche active peut comporter des moyens de confinement, tels que des puits quantiques multiples. Elle est, par exemple, constituée d'une alternance de couches de GaN et de InGaN ayant des épaisseurs respectives de 3 à 20 nm (par exemple 6 nm) et de 1 à 10 nm (par exemple 2,5 nm) . Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure de type N du fil 20 de la jonction P-N ou P-I-N.

La couche de liaison peut correspondre à une couche semiconductrice ou à un empilement de couches semiconductrices et permet la formation d'un contact ohmique entre la couche intermédiaire et l'électrode 30. A titre d'exemple, la couche de liaison peut être dopée très fortement du type opposé à la portion inférieure 56, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 30 est adaptée à polariser la couche active recouvrant chaque élément semiconducteur 20 et à laisser passer le rayonnement électromagnétique émis par les diodes électroluminescentes DEL. Le matériau formant l'électrode 30 peut être un matériau transparent et conducteur tel que de l'oxyde d'indiumétain (ou ITO, acronyme anglais pour Indium Tin Oxide), de l'oxyde de zinc dopé ou non à l'aluminium ou au gallium, ou du graphène. A titre d'exemple, la couche d'électrode 30 a une épaisseur comprise entre 5 nm et 200 nm, de préférence entre 20 nm et 50 nm.

La couche d'encapsulation 34 est réalisée en un matériau isolant au moins partiellement transparent. L'épaisseur maximale de la couche d'encapsulation 34 est comprise entre 250 nm et 50 µm de sorte que la couche d'encapsulation 34 recouvre complètement l'électrode 30 au sommet des diodes électroluminescentes DEL.

A titre de variante, une couche conductrice miroir, non représentée, recouvrant la couche d'électrode 30 entre les portions supérieures 58 ou entre les pyramides 62, 66 mais ne s'étendant pas sur les éléments semiconducteurs 20, peut être prévue. La couche conductrice miroir peut correspondre à une couche métallique, par exemple en aluminium, en argent, en cuivre ou en zinc.

Selon une autre variante, le dispositif optoélectronique 50 peut, en outre, comprendre une couche de luminophores, non représentée, prévue sur la couche d'encapsulation 34 ou confondue avec celle-ci.

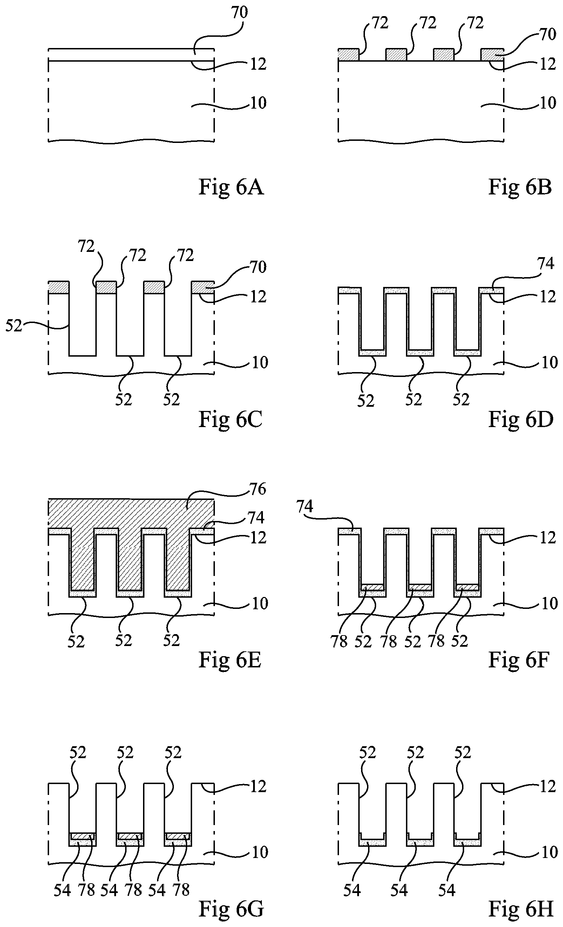

Des premières étapes d'un mode de réalisation d'un procédé de fabrication du dispositif optoélectronique 50 représenté en figure 3 vont être décrites en relation avec les figures 6A à 6H.

La figure 6A représente la structure obtenue après la formation d'une couche de résine 70 sur la face 12 du substrat 10.

La figure 6B représente la structure obtenue après la formation d'ouvertures 72 dans la couche de résine 70 de façon à exposer des parties de la face 12 du substrat 10, trois ouvertures 72 étant représentées à titre d'exemple en figure 6B. Les ouvertures 72 peuvent être formées par des étapes de lithographie, notamment par photolithographie, lithographie par nanoimpression, lithographie à faisceau d'électrons ou écriture directe.

La figure 6C illustre la structure obtenue après la gravure des ouvertures 52 dans le prolongement des ouvertures 72. Les ouvertures 52 peuvent être gravées par une gravure anisotrope, par exemple une gravure ionique réactive ou RIE (sigle anglais pour Reactive Ion Etching) ou une gravure au plasma couplé par induction ou gravure ICP (sigle anglais pour inductively coupled plasma).

La figure 6D représente la structure obtenue après le retrait de la couche de résine 70 et après le dépôt d'une couche 74 du matériau constituant les plots de germination, appelée couche de germination 74 par la suite, sur la totalité de la structure et notamment sur les parois latérales et sur le fond de chaque ouverture 52. De façon avantageuse, un grand nombre de procédés de dépôt peuvent être mis en oeuvre. En effet, le procédé de dépôt de la couche 74 peut être un procédé de dépôt conforme, directif ou intermédiaire entre un procédé de dépôt conforme et un procédé de dépôt directif. Dans le cas d'un dépôt directif, la couche 74 peut ne pas être continue.

La couche de germination 74 peut être déposée par un procédé du type dépôt chimique en phase vapeur (CVD, sigle anglais pour Chemical Vapor Déposition) ou dépôt chimique en phase vapeur organométallique (MOCVD), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Déposition). En outre, des procédés de dépôt physique en phase vapeur (PVD, sigle anglais pour Physical Vapor Déposition), tels l'évaporation ou la pulvérisation cathodique peuvent être utilisés.

L'épaisseur de la couche de germination 74 au fond de chaque ouverture 52 est comprise entre 1 et 100 nanomètres, de préférence comprise entre 10 et 30 nanomètres.

Lorsque la couche de germination 74 est en nitrure d'aluminium, elle peut être sensiblement texturée et posséder une polarité préférentielle. La texturation de la couche 74 peut être obtenue par un traitement supplémentaire réalisé après le dépôt de la couche de germination. Il s'agit, par exemple, d'un recuit sous flux d'ammoniac (NH₃).

La figure 6E représente la structure obtenue après le dépôt d'une couche de résine 76 sur la totalité de la structure. La résine est choisie de façon à remplir sensiblement la totalité de chaque ouverture 52, et peut être positive ou négative.

La figure 6F représente la structure obtenue après avoir gravé une partie de la couche de résine 76 de façon à exposer une partie de la couche de nucléation 74 et à laisser une portion 78 de résine dans chaque ouverture 52. La gravure est, par exemple, une gravure au plasma utilisant un plasma d'oxygène mais peut également comprendre, dans le cas d'une résine positive, une exposition et un développement partiels de la résine (ajustement de l'énergie d'exposition) ou une combinaison des deux procédés exposition/développement et d'une gravure au plasma d'oxygène ou, dans le cas d'une résine négative, un développement partiel de la résine (ajustement de la durée de développement) ou une combinaison des deux procédés, développement et gravure au plasma d'oxygène.

De préférence, l'épaisseur de chaque portion de résine 78 est au moins égale à l'épaisseur de la couche de nucléation 74 au fond de chaque ouverture 52. De préférence, l'épaisseur de chaque portion de résine 78 est comprise entre 1 et 100 nanomètres, de préférence comprise entre 10 et 30 nanomètres.

La figure 6G représente la structure obtenue après une étape de gravure des parties exposées de la couche de nucléation de façon à laisser les parties de la couche de nucléation qui étaient recouvertes par les portions de résine 78 et qui correspondent aux plots de germination 54. La gravure est une gravure anisotrope, par exemple une gravure au plasma ou une gravure chimique. De préférence, la gravure est sélective par rapport au matériau composant la résine. Chaque plot de germination 54 recouvre le fond de l'ouverture 52 associée et peut, en outre, recouvrir une partie des parois latérales de l'ouverture 52 sur une hauteur inférieure ou égale à l'épaisseur de la portion de résine 78. Le fait que l'épaisseur des portions de résine 78 soit sensiblement égale à l'épaisseur de la couche de nucléation 74 au fond des ouvertures 72 permet d'éviter une gravure de la couche de nucléation 74 au fond des ouvertures 72 dans le cas où la gravure n'est pas sélective ou pas suffisamment sélective par rapport aux portions de résine 78.

La figure 6H représente la structure obtenue après le retrait des portions de résine 78 pour exposer les plots de germination 54. Le retrait des portions de résine 78 peut être réalisé par le trempage de la structure représentée en figure 6G dans un bain contenant un solvant adapté à dissoudre les portions de résine 78.

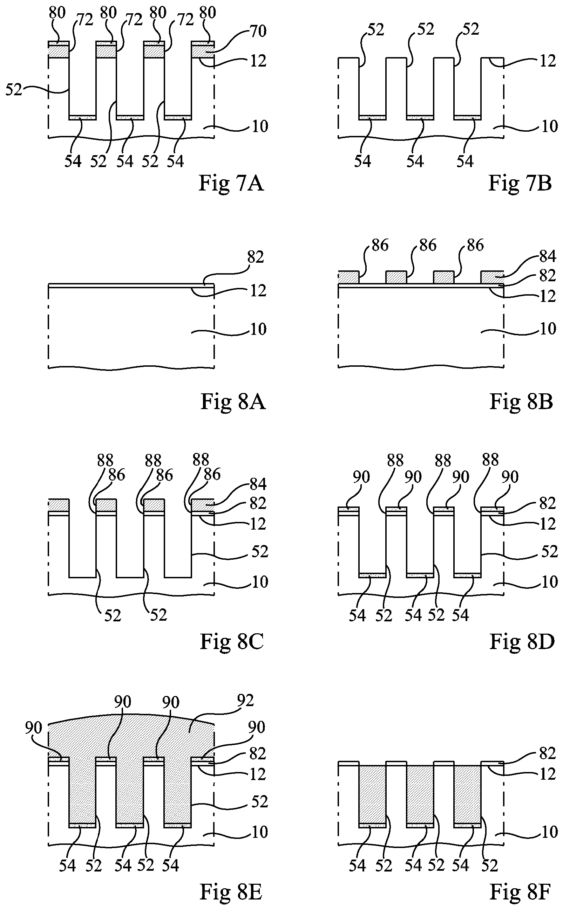

Des premières étapes d'un autre mode de réalisation d'un procédé de fabrication du dispositif optoélectronique 50 représenté en figure 3 vont être décrites en relation avec les figures 7A et 7B. Ce mode de réalisation comprend les étapes décrites précédemment en relation avec les figures 6A à 6C.

La figure 7A représente la structure obtenue après la formation des plots de germination 54 au fond des ouvertures 52 et la formation de portions 80 du matériau constituant les plots de germination sur la face supérieure de la couche de résine 70. Selon un mode de réalisation, le procédé de formation des plots 54 et des portions 80 est un procédé de dépôt directif de façon qu'il n'y ait pas de dépôt du matériau constituant les plots de germination sur les parois latérales des ouvertures 52. Selon un mode de réalisation, le procédé de dépôt est un procédé de dépôt par pulvérisation cathodique collimatée ou par évaporation. Toutefois, dans ce cas, le rapport F entre la hauteur H et le diamètre L est de préférence inférieur à 1 de façon à obtenir un dépôt convenable au fond des ouvertures 52.

La figure 7B représente la structure obtenue après le retrait de la couche de résine 70, ce qui entraîne également le retrait des portions 80. Le retrait de la couche de résine peut être réalisé par le trempage de la structure représentée en figure 7A dans un bain contenant un solvant adapté à dissoudre la couche de résine 70.

Des premières étapes d'un autre mode de réalisation d'un procédé de fabrication du dispositif optoélectronique 50 représenté en figure 3 vont être décrites en relation avec les figures 8A à 8H.

La figure 8A représente la structure obtenue après la formation d'une deuxième couche isolante 82 sur la face 12 du substrat 10. La deuxième couche isolante 82 peut être une couche d'oxyde de silicium. La deuxième couche isolante 82 peut être déposée par exemple selon un dépôt conforme, notamment par CVD. A titre de variante, la deuxième couche isolante 82 peut être obtenue par oxydation thermique du substrat 10. L'épaisseur de la deuxième couche isolante 82 peut être comprise entre 5 nm et 100 nm.

La figure 8B représente la structure obtenue après la formation d'une couche de résine 84 sur la face 12 du substrat 10 et la formation d'ouvertures 86 dans la couche de résine 84 de façon à exposer des parties de la deuxième couche isolante 82, trois ouvertures 86 étant représentées à titre d'exemple en figure 8B.

La couche de résine 84 peut avoir la même composition et la même épaisseur que la couche de résine 70 décrite précédemment. Les ouvertures 86 peuvent être formées par des étapes de photolithographie.

La figure 8C représente la structure obtenue après la gravure d'ouvertures 88 dans la deuxième couche isolante 82, dans le prolongement des ouvertures 72, et la gravure des ouvertures 52 dans le prolongement des ouvertures 88.

La figure 8D représente la structure obtenue après le retrait de la couche de résine 84 puis la formation des plots de germination 54 au fond des ouvertures 52 et la formation de portions 90 du matériau constituant les plots de germination sur la face supérieure de la deuxième couche isolante 82. Selon un mode de réalisation, le procédé de formation des plots 54 et des portions 90 est un procédé de dépôt directif de façon qu'il n'y ait pas de dépôt du matériau constituant les plots de germination sur les parois latérales des ouvertures 52. Selon un mode de réalisation, le procédé de dépôt est un procédé de dépôt par pulvérisation cathodique collimatée ou par évaporation. Toutefois, dans ce cas, le rapport F entre la hauteur H et le diamètre L est de préférence inférieur à 1 de façon à obtenir un dépôt convenable au fond des ouvertures 52.

La figure 8E représente la structure obtenue après le dépôt d'une couche de résine 92 sur la totalité de la structure, de sorte que la couche de résine 92 remplisse sensiblement la totalité de chaque ouverture 52.

La figure 8F représente la structure obtenue après le retrait d'une partie de la couche de résine 92 et le retrait des portions 90 de façon à exposer la deuxième couche isolante 82. La gravure de la couche de résine 92 met, par exemple, en oeuvre un procédé de planarisation mécano-chimique ou CMP (sigle anglais pour Chemical-Mechanical Planarization). La couche isolante 80 joue alors le rôle de couche d'arrêt de gravure pour la CMP. Des portions 92 de la couche de résine 70 sont laissées dans les ouvertures 52.

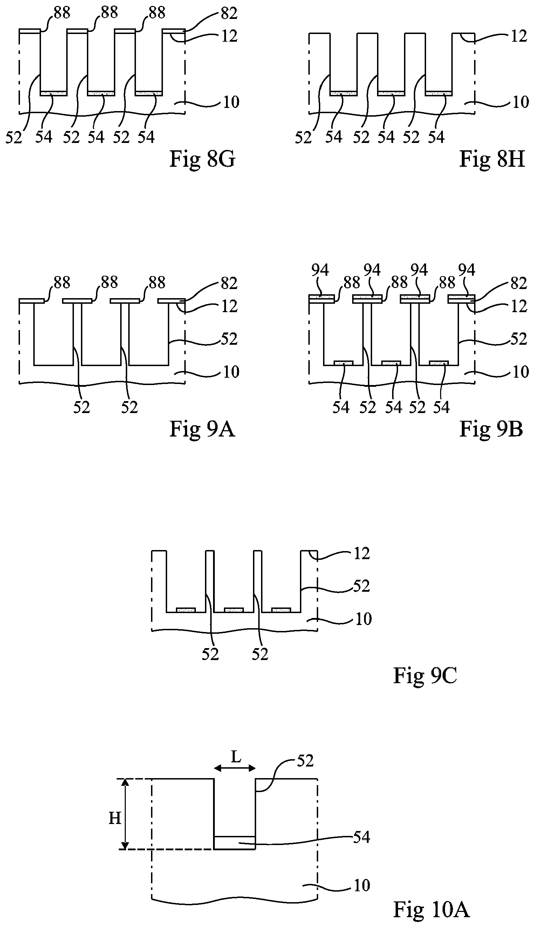

La figure 8G représente la structure obtenue après le retrait du reste des portions 92 de la couche de résine de façon à exposer les plots de germination 54. Le retrait des portions 92 de la couche de résine peut être réalisé par le trempage de la structure représentée en figure 8F dans un bain contenant un solvant adapté à dissoudre la résine.

La figure 8H représente la structure obtenue après la gravure de la deuxième couche isolante 82. Cette étape peut ne pas être présente.

Des premières étapes d'un autre mode de réalisation d'un procédé de fabrication du dispositif optoélectronique 50 représenté en figure 3 vont être décrites en relation avec les figures 9A à 9C. Ce mode de réalisation comprend les étapes décrites précédemment en relation avec les figures 8A à 8C.

La figure 9A représente la structure obtenue après le retrait de la couche de résine 84 et la gravure du substrat 10 pour agrandir le diamètre des ouvertures 52. La gravure du substrat 10 peut être une gravure chimique humique anisotrope utilisant une solution aqueuse d'hydroxyde de potassium (KOH) ou d'hydroxyde de tétraméthylammonium (TMAH). La gravure du substrat 10 est une gravure sélective par rapport au matériau constituant la deuxième couche isolante 82 de sorte que, à la fin de l'étape de gravure, le diamètre de chaque ouverture 52 est supérieur au diamètre de l'ouverture 88 associée.

La figure 9B représente la structure obtenue après la formation des plots de germination 54 au fond des ouvertures 52 et la formation de portions 94 du matériau constituant les plots de germination sur la face supérieure de la deuxième couche isolante 82. Selon un mode de réalisation, le procédé de formation des plots 54 et des portions 94 est un procédé de dépôt directif. Selon un mode de réalisation, le procédé de dépôt est un procédé de dépôt par pulvérisation cathodique collimatée ou par évaporation. Toutefois, dans ce cas, le rapport entre la hauteur H de l'ouverture 52 et le diamètre des ouvertures 88 est de préférence inférieur à 1 de façon à obtenir un dépôt convenable au fond des ouvertures 52. Selon un autre mode de réalisation, le procédé de formation des plots 54 et des portions 94 est un procédé de dépôt intermédiaire entre un dépôt directif et un dépôt conforme. Dans ce cas, l'ombrage des parois latérales de chaque ouverture 52 par la deuxième couche isolante 82 en raison de la différence entre le diamètre de l'ouverture 88 et le diamètre de l'ouverture 52 est suffisamment important pour empêcher le dépôt du matériau composant les plots de germination sur ces parois latérales.

La figure 9C représente la structure obtenue après le retrait de la deuxième couche isolante 82, ce qui entraîne également le retrait des portions 94. Le retrait de la deuxième couche isolante 82 peut être réalisé en utilisant une solution gravante de type BOE (sigle anglais pour Buffered Oxide Etch).

Des étapes ultérieures d'un mode de réalisation d'un procédé de fabrication du dispositif optoélectronique 50 représenté en figure 3 vont maintenant être décrites en relation avec les figures 10A à 10C.

La figure 10A illustre la structure obtenue après la formation des ouvertures 52 et des plots de germination 54 au fond de chaque ouverture 52. L'un quelconque des modes de réalisation décrits précédemment en relation avec les figures 6A à 6H, 7A et 7B, 8A à 8H et 9A à 9C peut être mis en oeuvre pour l'obtention de la structure représentée en figure 10A. Dans le cas où le mode de réalisation décrit précédemment en relation avec les figures 6A à 6H est mise en oeuvre, chaque plot de germination 54 peut, en outre, s'étendre sur une partie des parois latérales de l'ouverture 52. Dans le cas où le mode de réalisation décrit précédemment en relation avec les figures 9A à 9C est mis en oeuvre, chaque plot de germination 54 peut ne pas s'étendre sur la totalité du fond de l'ouverture 52 associée.

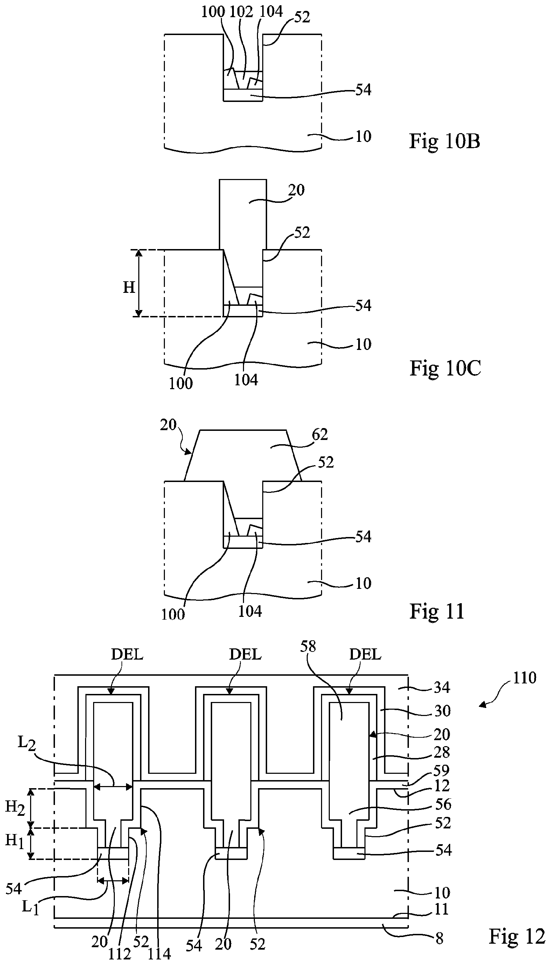

La figure 10B illustre la structure obtenue après l'étape suivante :
(1) Formation de germes dans chaque ouverture 52, trois germes 100, 102, 104 étant représentés à titre d'exemple en figure 10B.

Le procédé de formation des germes 100, 102, 104 peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

A titre d'exemple, le procédé de formation de germes peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).

Cette étape peut conduire à la formation de la couche isolante 59, non représentée sur les figures 10A à 10C. Selon un mode de réalisation, la température dans le réacteur à l'étape (1) est inférieure ou égale à 1000 °C, de préférence inférieure ou égale à 820°C.

Selon un mode de réalisation, le rapport entre le flux du gaz précurseur de l'élément du groupe V et le flux du gaz précurseur de l'élément du groupe III, ou rapport V/III, à l'étape (1) est supérieur ou égal à 1000, de préférence supérieur ou égal à 5000.

La figure 10C illustre la structure obtenue après l'étape suivante :
(2) Croissance d'un élément semiconducteur 20 en forme de fil dans chaque ouverture 52.

Le procédé de croissance des fils 20 peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

Comme cela apparaît sur la figure 10C, la hauteur H suffisamment élevée de l'ouverture 52 entraîne que seul le fil dont l'axe de croissance est sensiblement parallèle à l'axe de l'ouverture 52 parvient à croître à l'extérieur de l'ouverture 52.

Par rapport à un procédé de fabrication dans lequel les fils 20 sont formés dans des ouvertures d'une couche isolante recouvrant le substrat, un avantage des modes de réalisation décrits précédemment dans lesquels les fils 20 croissent depuis les ouvertures 52 est que les contraintes dans le substrat 10 dues aux différences de dilatation entre la couche isolante et le substrat lors de la formation des fils 20 sont réduites.

Les étapes ultérieures du procédé de fabrication du dispositif optoélectronique 50 sont les suivantes :
(3) Formation par épitaxie, pour chaque fil 20, des couches composant la coque 28. Le dépôt des couches composant la coque 28 ne se produit que sur la portion du fil 20 hors de l'ouverture 52.
(4) Formation de la deuxième électrode 30, par exemple par dépôt conforme.
(5) Formation de la couche d'encapsulation 34. Lorsque la couche d'encapsulation 34 est en silicone, la couche d'encapsulation 34 peut être déposée par un procédé de dépôt à la tournette, par un procédé d'impression par jet ou par un procédé de sérigraphie. Lorsque la couche d'encapsulation 34 est un oxyde, elle peut être déposée par CVD.
(6) Formation par dépôt de la première électrode 8, recouvrant la face inférieure 11 du substrat 10.
(7) Découpe du substrat 10 pour séparer les dispositifs optoélectroniques.

A titre d'exemple, l'étape (6) décrite précédemment peut être réalisée entre l'étape (4) et l'étape (5) décrites précédemment ou entre l'étape (3) et l'étape (4) décrites précédemment.

Un mode de réalisation d'un procédé de fabrication des dispositifs optoélectroniques 60 ou 65, représentés respectivement en figure 4 ou 5, comprend les étapes (1) à (7) décrites précédemment à la différence que l'étape (2) est remplacée par l'étape (8) suivante :
(8) Croissance de la portion inférieure 56 de chaque élément semiconducteur 20 dans chaque ouverture 52 et croissance des pyramides 62, 66 en dehors de chaque ouverture 52. Le procédé de croissance des pyramides 62, 66 peut être un procédé du type CVD, MOCVD, MBE, GSMBE, PAMBE, ALE, HVPE, ALD. En outre, des procédés électrochimiques peuvent être utilisés, par exemple, le procédé CBD, les procédés hydrothermiques, la pyrolyse d'aérosol liquide ou l'électrodépôt. Les conditions de croissances sont choisies afin de faire croître les structures cristallines préférentiellement sous forme de pyramides et non de fils.

La figure 11 représente la structure obtenue à l'étape (8) au cours de la croissance de la pyramide 62.

Dans les modes de réalisation décrits précédemment, les ouvertures 52 ont un diamètre sensiblement constant sur toute leur hauteur.

Selon un autre mode de réalisation, le diamètre de chaque ouverture 52 peut ne pas être constant sur la totalité de la hauteur de l'ouverture.

La figure 12 est une vue en coupe, partielle et schématique, d'un autre mode de réalisation d'un dispositif optoélectronique 110 à diodes électroluminescentes. Le dispositif optoélectronique 110 comprend les mêmes éléments que le dispositif optoélectronique 50 représenté en figure 3 à la différence que l'ouverture 52 comprend des première et deuxième parties d'ouverture successives 112, 114 ayant des diamètres différents, la première partie d'ouverture 112 étant la plus proche du fond de l'ouverture. La première partie d'ouverture 112 peut avoir une hauteur H₁ et un diamètre L₁, de préférence sensiblement constant sur toute la hauteur H₁. La deuxième partie d'ouverture 114 peut avoir une hauteur H₂ et un diamètre L₂, de préférence sensiblement constant sur toute la hauteur H₂.

Selon un mode de réalisation, le diamètre L₁ est strictement inférieur au diamètre L₂. A titre d'exemple, la hauteur H₁ est comprise entre 30 nm et 500 nm, de préférence entre 100 nm et 300 nm. A titre d'exemple, le diamètre L₁ est compris entre 30 nm et 1 µm, de préférence entre 100 nm et 600 nm. Le rapport F₁ entre la hauteur H₁ et le diamètre L₁ est compris entre 0,1 et 4, de préférence entre 0,75 et 1,5. A titre d'exemple, la hauteur H₂ est comprise entre 200 nm et 2000 nm, de préférence entre 250 nm et 500 nm. A titre d'exemple, le diamètre L₂ est compris entre 50 nm et 2 µm, de préférence entre 150 nm et 800 nm. Le rapport F₂ entre la hauteur H₂ et le diamètre L₂ est compris entre 0,1 et 4, de préférence entre 0,75 et 1,5. Le diamètre L₁ est sélectionné pour favoriser la croissance d'un germe unique dans l'ouverture 52. Le diamètre L₂ est sélectionné en fonction du diamètre souhaité du fil.

De façon avantageuse, les dimensions de la première partie d'ouverture sont un paramètre de commande de la formation des germes et les dimensions de la deuxième partie d'ouverture sont un paramètre de commande de la sélection d'un fil unique. De ce fait, les paramètres de commande de la formation des germes et de sélection d'un fil unique ne dépendent pas d'une seule ouverture et peuvent être ajustés indépendamment.

Dans les modes de réalisation décrits précédemment, la coque 28 recouvre chaque fil 20 jusqu'à la couche isolante 59. Toutefois, à titre de variante, il peut être prévu une couche isolante qui recouvre une partie des flancs latéraux de chaque fil 20 sur une partie de la hauteur des fils 20 en dehors des ouvertures 52. La coque 28 recouvre alors les flancs latéraux des fils 20 sauf aux emplacements où cette couche isolante est présente. Cette couche isolante peut, en outre, recouvrir une partie de la coque 28.

Des modes de réalisation particuliers de la présente invention ont été décrits. Bien que des modes de réalisation aient été décrits pour un dispositif optoélectronique pour lequel la coque 28 recouvre le sommet du fil 20 associé et une partie des flancs latéraux du fil 20, la coque peut n'être prévue qu'au sommet du fil 20.

## Revendications

1. Dispositif optoélectronique (50 ; 60 ; 65) comprenant :
un substrat monobloc (10) comprenant une face (12), le substrat (10) étant en silicium, en germanium, en carbure de silicium, en un composé III-V, ou en ZnO ;
des ouvertures non traversantes (52) s'étendant dans le substrat depuis la face ;
une couche isolante (59) s'étendant sur la face et sur les parois latérales, à l'exception du fond, de chaque ouverture, la couche isolante (59) étant en un matériau diélectrique parmi l'oxyde de silicium , SiO₂ le nitrure de silicium ,SiₓN_{y'} où x est environ égal à 3 et y est environ égal à 4, l'oxynitrure de silicium, l'oxyde d'hafnium , HfO₂, ou le diamant ;
une pluralité d'éléments semiconducteurs (20) ;
un plot (54) au fond de chaque ouverture (52) en au moins un premier matériau choisi parmi le groupe comprenant le nitrure d'aluminium, AlN le bore, B , le nitrure de bore, BN, le titane , Ti, le nitrure de titane, TiN , le tantale, Ta, le nitrure de tantale, TaN, l'hafnium, Hf , le nitrure d'hafnium, HfN, le niobium, Nb, le nitrure de niobium, NbN , le zirconium, Zr, le borate de zirconium, ZrB₂ , le nitrure de zirconium, ZrN, le carbure de silicium, sic , le nitrure et carbure de tantale , TaCN , le nitrure de magnésium sous la forme MgₓN_{y}, où x est égal à 3 à 10 % près et y est égal à 2 à 10 % près, ou le nitrure de gallium ;
pour chaque plot, un élément semiconducteur parmi ladite pluralité d'éléments semiconducteurs reposant sur ledit plot, s'étendant en partie dans l'ouverture (52) contenant ledit plot et en partie à l'extérieur de l'ouverture, un seul élément semiconducteur étant présent dans chaque ouverture, les plots étant en un matériau favorisant la croissance des éléments semiconducteurs, la hauteur (H) de chaque ouverture étant supérieure ou égale à 25 nm et inférieure ou égale à 5 µm et le rapport entre la hauteur (H) et le plus petit diamètre équivalent de chaque ouverture (L) étant supérieur ou égal à 0,5 et inférieur ou égal à 15, le diamètre équivalent correspondant au diamètre du disque ayant la même surface que la section droite de l'ouverture, chaque élément semiconducteur (20) étant un nanofil, un microfil ou une structure pyramidale de taille nanométrique ou micrométrique s'étendant selon un axe perpendiculaire à ladite face, chaque élément semiconducteur (20) étant majoritairement en un composé III-V ou un composé II-VI ; et
pour chaque élément semiconducteur (20), une coque (28) comprenant au moins une couche active recouvrant en partie l'élément semiconducteur, et adaptée à émettre ou à absorber un rayonnement électromagnétique.

2. Dispositif optoélectronique selon la revendication 1, dans lequel la hauteur (H) est supérieure ou égale à 100 nm.

3. Dispositif optoélectronique selon la revendication 1 ou 2, dans lequel la hauteur (H) est supérieure ou égale à 500 nm.

4. Dispositif optoélectronique selon l'une quelconque des revendications 1 à 3, dans lequel le diamètre équivalent (L) de chaque ouverture (52) est constant sur toute la hauteur de l'ouverture.

5. Dispositif optoélectronique selon l'une quelconque des revendications 1 à 4, dans lequel l'épaisseur de la couche isolante (59) est comprise entre 5 nm et 100 nm.

6. Dispositif optoélectronique selon l'une quelconque des revendications 1 à 5, dans lequel la coque (28) recouvre le sommet de l'élément semiconducteur et au moins une partie des flancs latéraux de l'élément semiconducteur.

7. Procédé de fabrication d'un dispositif optoélectronique (50 ; 60 ; 65) comprenant les étapes suivantes :
former dans un substrat monobloc (10), comprenant une face (12), des ouvertures (52) non traversantes s'étendant dans le substrat depuis la face, la hauteur (H) de chaque ouverture étant supérieure ou égale à 25 nm et inférieure ou égale à 5 µm et le rapport entre la hauteur et le plus petit diamètre équivalent de chaque ouverture étant supérieur ou égal à 0,5 et inférieur ou égal à 15, le diamètre équivalent correspondant au diamètre du disque ayant la même surface que la section droite de l'ouverture, le substrat (10) étant en silicium, en germanium, en carbure de silicium, en un composé III-V, ou en ZnO ;
former une couche isolante (59) s'étendant sur la face et sur les parois latérales, à l'exception du fond, de chaque ouverture, la couche isolante (59) étant en un matériau diélectrique parmi l'oxyde de silicium , SiO₂, , le nitrure de silicium, SiₓN_{y}, où x est environ égal à 3 et y est environ égal à l'oxynitrure de silicium, l'oxyde d'hafnium, HfO₂, ou le diamant ;
former un plot (54) au fond de chaque ouverture (52) en au moins un premier matériau choisi parmi le groupe comprenant le nitrure d'aluminium , AlN , le bore , B , le nitrure de bore, BN, le titane , Ti, le nitrure de titane, TiN , le tantale, Ta, le nitrure de tantale, TaN, l'hafnium, Hf , le nitrure d'hafnium, HfN, le niobium, Nb, le nitrure de niobium, NbN , le zirconium, Zr, le borate de zirconium, ZrB₂ , le nitrure de zirconium, ZrN, le carbure de silicium, sic , le nitrure et carbure de tantale , TaCN , le nitrure de magnésium sous la forme MgₓN_{y}, où x est à 10 % près égal à 3 et v est égal à 2 à 10 % près, ou le nitrure de gallium et de magnésium , MgGaN , le tungstène, W, le nitrure de tungstène, WN, ou une combinaison de ceux-ci ;
pour chaque plot, faire croître un élément semiconducteur (20) reposant sur ledit plot, successivement en partie dans l'ouverture contenant ledit plot et à l'extérieur de l'ouverture, un seul élément semiconducteur étant présent dans chaque ouverture, les plots étant en un matériau favorisant la croissance des éléments semiconducteurs, chaque élément semiconducteur (20) étant un nanofil, un microfil ou une structure pyramidale de taille nanométrique ou micrométrique s'étendant selon un axe perpendiculaire à ladite face, chaque élément semiconducteur (20) étant majoritairement en un composé III-V ou un composé II-VI ; et
pour chaque élément semiconducteur (20), former une coque (28) comprenant au moins une couche active recouvrant en partie l'élément semiconducteur, et adaptée à émettre ou à absorber un rayonnement électromagnétique.

8. Procédé selon la revendication 7, dans lequel la hauteur (H) de chaque ouverture (52) est supérieure ou égale à 100 nm.

9. Procédé selon la revendication 7 ou 8, comprenant les étapes suivantes :
graver les ouvertures (52) dans le substrat (10) ;
déposer une couche du premier matériau sur le substrat (10) , y compris dans les ouvertures ; et
graver ladite couche pour ne laisser que lesdits plots.

10. Procédé selon la revendication 7, comprenant les étapes suivantes :
déposer une couche de résine (70) sur la face (12) ;
graver la couche de résine et le substrat (10) pour former les ouvertures (52) ;
former les plots (54) du premier matériau et des premières portions (80) du premier matériau sur la couche de résine ; et
retirer la couche de résine et les premières portions.

11. Procédé selon la revendication 7, comprenant les étapes suivantes :
(a) déposer une deuxième couche isolante (82) sur la face (12) ;
(b) graver la deuxième couche isolante et le substrat (10) pour former les ouvertures (52) ;
(c) former, par un dépôt anisotrope, les plots (54) du premier matériau et des deuxièmes portions (90) du premier matériau sur la deuxième couche isolante ; et
(d) retirer les deuxièmes portions et la deuxième couche isolante.

12. Procédé selon la revendication 11, comprenant, après l'étape (b), une étape de gravure isotrope du substrat (10) sélective par rapport à la deuxième couche isolante.

## Patentansprüche

1. Optoelektronische Vorrichtung (50; 60; 65), aufweisend:
- ein Monoblock-Substrat (10) mit einer Oberfläche (12), wobei das Substrat (10) aus Silizium, Germanium, Siliziumkarbid, einer III-V-Verbindung oder ZnO hergestellt ist;
- Nicht-Durchgangsöffnungen (52), die sich von der Oberfläche in das Substrat erstrecken;
- eine Isolierschicht (59), die sich auf der Oberfläche und auf den Seitenwänden, mit Ausnahme des Bodens, jeder Öffnung erstreckt, wobei die Isolierschicht (59) aus einem dielektrischen Material aus Siliziumoxid, SiO₂, Siliziumnitrid, SiₓN_{y}, wobei x ungefähr gleich 3 und y ungefähr gleich 4 ist, Siliziumoxynitrid, Hafniumoxid, HfO₂ oder Diamant besteht;
- eine Vielzahl von Halbleiterelementen (20);
- einen Kontakt (54) am Boden jeder Öffnung (52) aus mindestens einem ersten Material, das aus der Gruppe ausgewählt ist, die Aluminiumnitrid, AlN, Bor, B, Bornitrid, BN, Titan, Ti, Titannitrid, TiN, Tantal, Ta, Tantalnitrid, TaN, Hafnium, Hf, Hafniumnitrid, HfN, Niob, Nb, Niobnitrid, NbN, Zirkonium, Zr, Zirkoniumborat, ZrB₂, Zirkoniumnitrid, ZrN, Siliziumcarbid, SiC, Tantalcarbidnitrid, TaCN, Magnesiumnitrid in Form von MgₓN_{y}, wobei x gleich 3 ± 10% und y gleich 2 ± 10% ist, oder Galliumnitrid aufweist;
für jeden Kontakt ein Halbleiterelement aus der Vielzahl der Halbleiterelemente auf dem Kontakt, das sich teilweise in die den Kontakt enthaltende Öffnung (52) und teilweise außerhalb der Öffnung erstreckt, wobei in jeder Öffnung ein einziges Halbleiterelement vorhanden ist, wobei die Kontakte aus einem das Wachstum der Halbleiterelemente begünstigenden Material bestehen, die Höhe (H) jeder Öffnung größer als oder gleich 25 nm und kleiner als oder gleich 5 µm ist und das Verhältnis der Höhe (H) zum kleinsten äquivalenten Durchmesser jeder Öffnung (L) größer als oder gleich 0.5 und kleiner als oder gleich 15 ist, wobei der äquivalente Durchmesser dem Durchmesser der Kreisscheibe mit der gleichen Fläche wie der des Querschnitts der Öffnung entspricht, wobei jedes Halbleiterelement (20) ein Nanodraht, ein Mikrodraht oder eine pyramidenförmige Struktur im Nanometer- oder Mikrometerbereich ist, die sich entlang einer Achse senkrecht zu der Oberfläche erstreckt, wobei jedes Halbleiterelement (20) hauptsächlich aus einer III-V-Verbindung oder einer II-VI-Verbindung hergestellt ist; und
für jedes Halbleiterelement (20) eine Hülle (28) mit mindestens einer aktiven Schicht, die das Halbleiterelement teilweise bedeckt und eine Strahlung emittieren oder absorbieren kann.

2. Optoelektronische Vorrichtung nach Anspruch 1, wobei die Höhe (H) größer als oder gleich 100 nm ist.

3. Optoelektronische Vorrichtung nach Anspruch 1 oder 2, wobei die Höhe (H) größer als oder gleich 500 nm ist.

4. Optoelektronische Vorrichtung nach einem der Ansprüche 1 bis 3, wobei der äquivalente Durchmesser (L) jeder Öffnung (52) über die gesamte Höhe der Öffnung konstant ist.

5. Optoelektronische Vorrichtung nach einem der Ansprüche 1 bis 4, wobei die Dicke der Isolierschicht (59) im Bereich von 5 nm bis 100 nm liegt.

6. Optoelektronische Vorrichtung nach einem der Ansprüche 1 bis 5, wobei die Hülle (28) die Oberseite des Halbleiterelements und zumindest einen Teil der lateralen Seiten des Halbleiterelements bedeckt.

7. Verfahren zur Herstellung einer optoelektronischen Vorrichtung (50; 60; 65), das die folgenden Schritte aufweist:
Ausbilden, in einem Monoblock-Substrat (10), das eine Oberfläche (12) aufweist, von nicht durchgehenden Öffnungen (52), die sich von der Oberfläche aus in das Substrat erstrecken, wobei die Höhe (H) jeder Öffnung größer oder gleich 25 nm und kleiner oder gleich 5 µm ist und das Verhältnis der Höhe zum kleinsten äquivalenten Durchmesser jeder Öffnung größer oder gleich 0.5 und kleiner als oder gleich 15 ist, wobei der äquivalente Durchmesser dem Durchmesser der Kreisscheibe entspricht, die die gleiche Fläche wie der Querschnitt der Öffnung hat, wobei das Substrat (10) aus Silizium, Germanium, Siliziumkarbid, einer III-V-Verbindung oder ZnO hergestellt ist;
Ausbilden einer Isolierschicht (59), die sich auf der Oberfläche und an den Seitenwänden, mit Ausnahme des Bodens, jeder Öffnung erstreckt, wobei die Isolierschicht (59) aus einem dielektrischen Material aus Siliziumoxid, SiO₂, Siliziumnitrid, SiₓN_{y}, wobei x ungefähr gleich 3 und y ungefähr gleich 4 ist, Siliziumoxynitrid, Hafniumoxid, HfO₂ oder Diamant besteht;
Ausbilden eines Kontakts (54) am Boden jeder Öffnung (52) aus mindestens einem ersten Material, das aus der Gruppe ausgewählt ist, die Aluminiumnitrid, AlN, Bor, B, Bornitrid, BN, Titan, Ti, Titannitrid, TiN, Tantal, Ta, Tantalnitrid, TaN, Hafnium, Hf, Hafniumnitrid, HfN, Niob, Nb, Niobnitrid, NbN, Zirkonium, Zr, Zirkoniumborat, ZrB₂, Zirkoniumnitrid, ZrN, Siliziumkarbid, SiC, Tantalkarbidnitrid, TaCN, Magnesiumnitrid in Form von MgₓN_{y}, wobei x gleich 3 ± 10 % und y gleich 2 ± 10 % ist, oder Galliummagnesiumnitrid, MgGaN, Wolfram, W, Wolframnitrid, WN, oder eine Kombination davon aufweist;
für jeden Kontakt das Aufwachsen eines Halbleiterelements (20) auf dem Kontakt, nacheinander teilweise in der Öffnung, die den Kontakt enthält, und außerhalb der Öffnung, wobei in jeder Öffnung ein einzelnes Halbleiterelement vorhanden ist, wobei die Kontakte aus einem Material hergestellt sind, das das Wachstum der Halbleiterelemente begünstigt, wobei jedes Halbleiterelement (20) ein Nanodraht, ein Mikrodraht oder eine pyramidenförmige Struktur im Nanometer-oder Mikrometerbereich ist, die sich entlang einer Achse senkrecht zu der Oberfläche erstreckt, wobei jedes Halbleiterelement (20) hauptsächlich aus einer III-V-Verbindung oder einer II-VI-Verbindung hergestellt ist; und
für jedes Halbleiterelement (20) das Ausbilden einer Hülle (28), die mindestens eine aktive Schicht aufweist, die das Halbleiterelement teilweise bedeckt und eine Strahlung emittieren oder absorbieren kann.

8. Verfahren nach Anspruch 7, wobei die Höhe (H) jeder Öffnung (52) größer als oder gleich 100 nm ist.

9. Verfahren nach Anspruch 7 oder 8, aufweisend die Schritte:
Ätzen der Öffnungen (52) in das Substrat (10);
Abscheiden einer Schicht aus dem ersten Material auf dem Substrat (10), einschließlich in den Öffnungen; und
Ätzen der Schicht, um nur die Kontakte zu belassen.

10. Verfahren nach Anspruch 7, aufweisend die Schritte:
Abscheiden einer Harzschicht (70) auf die Oberfläche (12);
Ätzen der Harzschicht und des Substrats (10) zur Bildung der Öffnungen (52);
Ausbilden der Pads (54) aus dem ersten Material und erster Abschnitte (80) des ersten Materials auf der Harzschicht; und
Entfernen der Harzschicht und der ersten Abschnitte.

11. Verfahren nach Anspruch 7, das die folgenden Schritte aufweist:
(a) Abscheiden einer zweiten Isolierschicht (82) auf die Oberfläche (12);
(b) Ätzen der zweiten Isolierschicht und des Substrats (10) zur Bildung der Öffnungen (52);
(c) Ausbilden, durch anisotropes Abscheiden, der Kontakte (54) des ersten Materials und zweiter Teile (90) des ersten Materials auf der zweiten Isolierschicht; und
(d) Entfernen der zweiten Abschnitte und der zweiten Isolierschicht.

12. Verfahren nach Anspruch 11, aufweisend nach Schritt (b) einen Schritt des isotropen Ätzens des Substrats (10) selektiv über der zweiten Isolierschicht.

## Claims

1. An optoelectronic device (50; 60; 65) comprising:
- a monoblock substrate (10) comprising a surface (12), the substrate (10) being made of silicon, germanium, silicon carbide, a III-V compound, or ZnO;
- non-through openings (52) extending into the substrate from the surface;
- an insulating layer (59) extending on the surface and on the lateral walls, except for the bottom, of each opening, the insulating layer (59) being made of a dielectric material among silicon oxide, SiO₂, silicon nitride, SiₓN_{y} where x is approximately equal to 3 and y is approximately equal to 4, silicon oxynitride, hafnium oxide, HfO₂, or diamond;
- a plurality of semiconductor elements (20);
- a pad (54) at the bottom of each opening (52) made of at least a first material selected from the group comprising aluminum nitride, AlN, boron, B, boron nitride, BN, titanium, Ti, titanium nitride, TiN, tantalum, Ta, tantalum nitride, TaN, hafnium, Hf, hafnium nitride, HfN, niobium, Nb, niobium nitride, NbN, zirconium, Zr, zirconium borate, ZrB₂, zirconium nitride, ZrN, silicon carbide, SiC, tantalum carbide nitride, TaCN, magnesium nitride in MgₓN_{y} form, where x is equal to 3 to within 10% and y is equal to 2 to within 10%, or gallium nitride;
for each pad, a semiconductor element among the plurality of semiconductor elements resting on said pad, extending partly in the opening (52) containing said pad and partly outside of the opening, a single semiconductor element being present in each opening, the pads being made of a material favoring the growth of the semiconductor elements, the height (H) of each opening being greater than or equal to 25 nm and smaller than or equal to 5 µm and the ratio of the height (H) to the smallest equivalent diameter of each opening (L) being greater than or equal to 0.5 and smaller than or equal to 15, the equivalent diameter corresponding to the diameter of the disk having the same surface area as the cross-section of the opening, each semiconductor elements (20) being a nanowire, a microwire, or a nanometer- or micrometer-range pyramidal structure extending according to an axis perpendicular to said surface, each semiconductor element (20) being made mainly of a III-V compound or a II-VI compound; and
for each semiconductor element (20), a shell (28) comprising at least one active layer partly covering the semiconductor element, and capable of emitting or of absorbing a radiation.

2. The optoelectronic device of claim 1, wherein the height (H) is greater than or equal to 100 nm.

3. The optoelectronic device of claim 1 or 2, wherein the height (H) is greater than or equal to 500 nm.

4. The optoelectronic device of any of claims 1 to 3, wherein the equivalent diameter (L) of each opening (52) is constant along the entire height of the opening.

5. The optoelectronic device of any of claims 1 to 4, wherein the thickness of the insulating layer (59) is in the range from 5 nm to 100 nm.

6. The optoelectronic device of any of claims 1 to 5, wherein the shell (28) covers the top of the semiconductor element and at least a part of the lateral sides of the semiconductor element.

7. A method of manufacturing an optoelectronic device (50; 60; 65), comprising the steps of:
forming in a monoblock substrate (10), comprising a surface (12), non-through openings (52) extending in the substrate from the surface, the height (H) of each opening being greater than or equal to 25 nm and smaller than or equal to 5 µm and the ratio of the height to the smallest equivalent diameter of each opening being greater than or equal to 0.5 and smaller than or equal to 15, the equivalent diameter corresponding to the diameter of the disk having the same surface area as the cross-section of the opening, the substrate (10) being made of silicon, germanium, silicon carbide, a III-V compound, or ZnO;
forming an insulating layer (59) extending on the surface and on the lateral walls, except for the bottom, of each opening, the insulating layer (59) being made of a dielectric material among silicon oxide, SiO₂, silicon nitride, SiₓN_{y} where x is approximately equal to 3 and y is approximately equal to 4, silicon oxynitride, hafnium oxide, HfO₂, or diamond;
forming a pad (54) at the bottom of each opening (52) made of at least a first material selected from the group comprising aluminum nitride, AlN, boron, B, boron nitride, BN, titanium, Ti, titanium nitride, TiN, tantalum, Ta, tantalum nitride, TaN, hafnium, Hf, hafnium nitride, HfN, niobium, Nb, niobium nitride, NbN, zirconium, Zr, zirconium borate, ZrB₂, zirconium nitride, ZrN, silicon carbide, SiC, tantalum carbide nitride, TaCN, magnesium nitride in MgₓN_{y} form, where x is equal to 3 to within 10% and y is equal to 2 to within 10%, or gallium magnesium nitride, MgGaN, tungsten, W, tungsten nitride, WN, or a combination thereof;
for each pad, growing a semiconductor element (20) resting on said pad, successively partly in the opening containing said pad and outside of the opening, a single semiconductor element being present in each opening, the pads being made of a material favoring the growth of the semiconductor elements, each semiconductor elements (20) being a nanowire, a microwire, or a nanometer- or micrometer-range pyramidal structure extending according to an axis perpendicular to said surface, each semiconductor element (20) being made mainly of a III-V compound or a II-VI compound; and
for each semiconductor element (20), forming a shell (28) comprising at least one active layer partly covering the semiconductor element, and capable of emitting or of absorbing a radiation.

8. The method of claim 7, wherein the height (H) of each opening (52) is greater than or equal to 100 nm.

9. The method of claim 7 or 8, comprising the steps of:
etching the openings (52) in the substrate (10);
depositing a layer of the first material on the substrate (10), including in the openings; and
etching said layer to only leave said pads.

10. The method of claim 7, comprising the steps of:
depositing a resin layer (70) on the surface (12);
etching the resin layer and the substrate (10) to form the openings (52);
forming the pads (54) of the first material and first portions (80) of the first material on the resin layer; and
removing the resin layer and the first portions.

11. The method of claim 7, comprising the steps of:
(a) depositing a second insulating layer (82) on the surface (12);
(b) etching the second insulating layer and the substrate (10) to form the openings (52);
(c) forming, by an anisotropic deposition, the pads (54) of the first material and second portions (90) of the first material on the second insulating layer; and
(d) removing the second portions and the second insulating layer.

12. The method of claim 11, comprising, after step (b), a step of isotropic etching of the substrate (10) selective over the second insulating layer.
